# EUROPEAN PATENT APPLICATION

(11) **EP 3 637 961 A1**
(43) Date of publication of application: **15.04.2020**
(21) Application number: 18199686.9
(22) Date of filing: 10.10.2018
(51) Int. Cl.: H05K 1/02, D04B 21/18, D03D 15/00, H01B 7/08, H05K 1/03, H05K 1/09, H05K 3/12

(54) **CONDUCTIVE THREADS AND METHODS OF FORMING CONDUCTIVE THREADS**

(71) Applicant: Nokia Technologies Oy, 02610 Espoo (FI)
(72) Inventor: DERRICK, Philip, Cambridge, Cambridgeshire CB3 0FA (GB); SASSI, Ugo, Cambridge, Cambridgeshire CB3 0FA (GB); RADIVOJEVIC, Zoran, Cambridge, Cambridgeshire CB3 0FA (GB)
(74) Representative: Swindell & Pearson Limited

(57) **Abstract**

The application relates to conductive threads (107) that could be used in fabrics (201) to make wearable electronic devices or other suitable types of fabrics. The conductive threads (107) comprise: a plurality of first conductive portions (101); at least one insulating layer (103), wherein the at least one insulating layer overlays at least part of the plurality of first conductive portions (101); and a plurality of second conductive portions (105) overlaying at least part of the at least one insulating layer (103) so that the plurality of second conductive portions (105) contacts the plurality of first conductive portions (101) to form at least one transmission line (109). The plurality of first conductive portions (101), the insulating layer (103), and the plurality of second conductive portions (105) are formed using one or more two dimensional printing processes.

## Description

### TECHNOLOGICAL FIELD

Examples of the present disclosure relate to conductive threads and methods of forming conductive threads. Some examples relate to conductive threads and methods of forming conductive threads for use in wearable electronic devices.

### FUNDING

The project leading to this application has received funding from the European Union's Horizon 2020 research and innovation program under grant agreement No 785219 - GrapheneCore2.

### BACKGROUND

Wearable electronic devices comprise electronic components which can be integrated within the fabric of an article of clothing or strap or other suitable means. The electronic components need to be comfortable, water and sweat proof and washable.

### BRIEF SUMMARY

According to various, but not necessarily all, examples of the disclosure there may be provided a conductive thread comprising: a plurality of first conductive portions; at least one insulating layer, wherein the at least one insulating layer overlays at least part of the plurality of first conductive portions; and a plurality of second conductive portions overlaying at least part of the at least one insulating layer so that the plurality of second conductive portions contacts the plurality of first conductive portions to form at least one transmission line; wherein the plurality of first conductive portions, the insulating layer, and the plurality of second conductive portions are formed using one or more two dimensional printing processes.

The plurality of first conductive portions may comprise at least a first subset and a second subset and the plurality of second conductive portions also comprise at least a first subset and a second subset wherein at least the first subset and the second subset are configured to form a pair of transmission lines. The pair of transmission lines may be formed in a twisted configuration.

Respective parts of the conductive thread may be formed using different two dimensional printing processes and the respective parts comprise the plurality of first conductive portions, the at least one insulating layer, and a plurality of second conductive portions.

The two dimensional printing processes may comprise one or more of; ink jet printing, screen printing, spray coating.

According to various, but not necessarily all, examples of the disclosure there may be provided a fabric formed using one or more conductive threads as claimed in any preceding claim.

The fabric may be formed using a weft knitting process.

The fabric may also comprise one or more non-conductive threads.

According to various, but not necessarily all, examples of the disclosure there may be provided a wearable electronic device comprising a conductive thread as described above and/or a fabric as described above.

According to various, but not necessarily all, examples of the disclosure there may be provided a wearable electronic device as described above wherein the conductive thread provides a connector within the wearable electronic device.

According to various, but not necessarily all, examples of the disclosure there may be provided a method of forming a conductive thread comprising: forming a plurality of first conductive portions; forming an insulating layer, wherein the first insulating layer overlays at least part of the plurality of first conductive portions; and forming a plurality of second conductive portions overlaying at least part of the insulating layer so that the plurality of second conductive portions contacts the plurality of first conductive portions to form at least one transmission line; wherein each of the plurality of first conductive portions, the insulating layer, and the plurality of second conductive portions are formed using one or more two dimensional printing processes.

The plurality of first conductive portions may comprise at least a first subset and a second subset and the plurality of second conductive portions form at least a second subset wherein at least the first subset and the second are configured to form a pair of transmission lines. The pair of transmission lines may be formed in a twisted configuration.

Respective parts of the conductive thread may be formed using different two dimensional printing processes and the respective parts comprise the plurality of first conductive portions, the at least one insulating layer, and a plurality of second conductive portions.

The two dimensional printing processes may comprise one or more of; ink jet printing, screen printing, spray coating.

According to various, but not necessarily all, examples of the disclosure there may be provided a method comprising forming a fabric using the conductive thread.

The fabric may be formed using a weft knitting process.

The fabric may also comprise non-conductive threads.

According to various, but not necessarily all, examples of the disclosure there may be provided a method comprising forming a wearable electronic device using one or more conductive threads formed using the methods as described above and/or fabric formed using the methods as described above.

The conductive thread may provide a connector within the wearable electronic device.

The fabric may comprising one or more conductive threads wherein the conductive threads comprise a twisted line transmission pair. The one or more conductive threads may be embedded within the fabric.

The fabric may be formed using a weft knitting process.

### BRIEF DESCRIPTION

Some example embodiments will now be described with reference to the accompanying drawings in which:
Figs. 1A to 1C show a method of forming a conductive thread;
Fig. 2 shows an example fabric that may comprise a conductive thread; and
Fig. 3 shows a wearable electronic device comprising conductive thread.

### DETAILED DESCRIPTION

Examples of the disclosure relate to a method of forming conductive thread 107 and different types of conductive threads 107 and fabrics 201 that may be formed by variations of the method. The method comprises forming the respective parts of the conductive thread 107 using one or more two dimensional printing processes. The respective parts of the conductive thread 107 may comprise at least; a plurality of first conductive portions 101, at least one insulating layer 103, wherein the at least one insulating layer 103 overlays at least part of the plurality of first conductive portions 101 and a plurality of second conductive portions 105 overlaying at least part of the at least one insulating layer 103 so that the plurality of second conductive portions 105 contacts the plurality of first conductive portions 101 to form at least one transmission line 109.

In some examples the conductive thread 107 may comprise a twisted pair transmission line in which a pair of transmission lines 109 are formed in a twisted configuration around an insulating core 103. The twisted configuration may be a helical configuration in which the transmission lines 109 are twisted around each other.

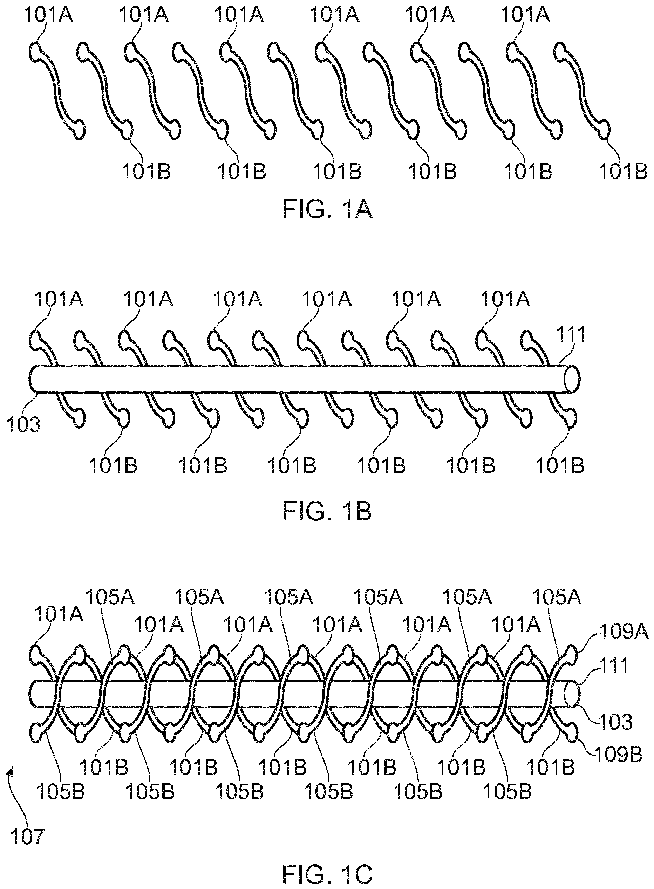

Figs. 1A to 1C show a method of forming a conductive thread 107 according to some examples of the disclosure.

In Fig. 1A a plurality of first conductive portions 101 are formed. The plurality of first conductive portions 101 are formed using a two dimensional printing process such as ink jet printing, screen printing, spray coating or any other suitable process. The printing process is two dimensional in that it produces a flat, or substantially flat, element on a flat, or substantially flat, surface. This is distinct from three dimensional printing processes, or other additive manufacturing processes, which build up multiple layers so as to create a three dimensional object. In examples of the dislocure the two dimensional printing processes may be used to create different parts of the conductive thread 107. The different parts may be combined to form a three dimensional conductive thread 107. Different two dimensional printing processes, and or different materials, may be used to form the different parts of the conductive thread 107.

The first conductive portions 101 may be formed from any conductive material which can be used in a two dimensional printing process. The conductive material may be provided in the form of a paste or ink for use in the two dimensional printing process. In some examples the conductive material could comprise carbon such as carbon black, carbon composites, graphene, carbon nanotubes, or any other suitable conductive carbon based material. In some examples the conductive material could comprise, copper silver, nickel, ferrite or any other suitable material.

In the example shown in Fig. 1A twelve first conductive portions 101 are shown. It is to be appreciated that any number of first conductive portions 101 could be printed in implementations of the disclosure.

The plurality of first conductive portions 101 are provided in two subsets. In the example of Fig. 1A equal numbers of first conductive portions 101 are provided in each of the subsets. In the example of Fig. 1A six first conductive portions 101 are provided in each of the subsets. In the example of Fig. 1A the first subset of first conductive portions 101 are labelled 101A and the second subset of first conductive portions 101 are labelled 101B.

The first subset may be used to form a first transmission line 109A and the second subset may be used to form a second transmission line 109B. The members of the two subsets are printed in an alternating sequence. The alternating sequence means that a first conductive portion 101A of the first subset has first conductive portions 101B of the second subset as nearest neighbors. Similarly a first conductive portion 101B of the second subset has first conductive portions 101A of the first subset as nearest neighbors. In some examples the first subset which forms a first transmission line 109A and the second subset which forms a second transmission line 109B may be printed in a single step. In some examples first subset and the second subset may be printed simultaneously.

The plurality of first conductive portions 101 are printed in a line so that they are spaced from each other. There is a gap between each of the plurality of first conductive portions 101 so that, at the stage of the method shown in Fig. 1A, there is no direct current path between the first conductive portions 101.

In the example shown in Fig. 1A each of the first conductive portions 101 has the same, or substantially the same shape. In the example shown in Fig. 1A the first conductive portions 101 are formed in a reverse S shape. The reverse S extends diagonally from a top left point to a bottom right point. It is to be appreciated that other shapes and configurations of the first conductive portions 101 could be used in other examples of the disclosure. In the example of Fig. 1A the different first conductive portions 101 in the different subsets have the same shape. In other examples the different first conductive portions 101 in the different subsets could have different shapes.

In Fig. 1B an insulating layer 103 is formed. The insulating layer 103 may provide an insulating core 111 of the conductive thread 107. The insulating layer 103 is formed using a two dimensional printing process such as ink jet printing, screen printing, spray coating or any other suitable process.

The insulating layer 103 may be formed from any suitable insulating material which can be used in a two dimensional printing process. The insulating material may be provided in the form of a paste or ink for use in the two dimensional printing process. In some examples the insulating material could comprise polymers such as polyethylene (PE), polyethylene terephthalate (PET), polyvinylchloride (PVC), polyurethane (PU), polyimide (PI), polypropylene (PP), polystyrene (PS), polymethylmethacrylate (PMMA) or any other suitable insulating material.

The insulating layer 103 is formed so that it overlays at least part of the plurality of first conductive portions 101. The insulating layer 103 may be printed over the plurality of first conductive portions 101 so that the insulating layer 103 is in direct contact with the plurality of first conductive portions 101. In this example there are no intervening components between the insulating layer 103 and the first conductive portions 101. In other examples there could be one or more intervening components.

In the example of Fig. 1B the first insulating layer 103 covers at least part of each of the plurality of first conductive portions 101. In other examples the first insulating layer 103 might cover parts of only a subset of the first conductive portions 101 so that some of the first conductive portions 101 are not covered by the first insulating layer 103.

In the example shown in Fig. 1B the insulating layer 103 is provided as an elongated strip that extends in a horizontal direction. The elongated strip covers at least part of the plurality of first conductive portions 101 and also parts of the gaps between adjacent first conductive portions 101. The insulating layer 103 has a width such that at least some parts of the first conductive portions 101 are not covered by the insulating layer 103. This leaves some parts of the first conductive portions 101 exposed and able to contact other conductive portions. In the example of Fig. 1B the insulating layer 103 covers both the first conductive portions 101A in the first subset and the first conductive portions 101B in the second subset.

In Fig. 1C a plurality of second conductive portions 105 are formed. The plurality of second conductive portions 105 are formed using a two dimensional printing process such as ink jet printing, screen printing, spray coating or any other suitable process.

The second conductive portions 105 may be formed from any conductive material which can be used in a two dimensional printing process. The second conductive portions 105 could be formed from the same type of material used for the first conductive portions 101.

In the example shown in Fig. 1C twelve second conductive portions 105 are shown. It is to be appreciated that any number of second conductive portions 105 could be printed in implementations of the disclosure. The number of second conductive portions 105 could be the same as the number of first conductive portions 101.

The plurality of second conductive portions 105 are also provided in two subsets. In the example of Fig. 1C equal numbers of second conductive portions 105 are provided in each of the subsets. In the example of Fig. 1C six second conductive portions 105 are provided in each of the subsets. In the example of Fig. 1C the first subset of second conductive portions 105 are labelled 105A and the second subset of second conductive portions 105 are labelled 105B.

The respective subsets of the second conductive portions 105 may be configured in an arrangement corresponding to the first conductive portions 101 so that the first subsets 101A, 105A may be used to form a first transmission line 109A and the second subsets 101B, 105B may be used to form a second transmission line 109B. The members of the two subsets of the second conductive portions 105 are also printed in an alternating sequence. The alternating sequence corresponds to the sequence that the first conductive portions 101 are printed in. The alternating sequence means that a second conductive portion 105A of the first subset has second conductive portions 105B of the second subset as nearest neighbors. Similarly a second conductive portion 105B of the second subset has second conductive portions 105A of the first subset as nearest neighbors. In some examples the first subset which forms a first transmission line 109A and the second subset which forms a second transmission line 109B may be printed in a single step. In some examples first subset and the second subset may be printed simultaneously.

The plurality of second conductive portions 105 are formed overlaying at least part of the insulating layer 103. The plurality of second conductive portions 105 may be printed over the insulating layer 103 so that the insulating layer 103 is in direct contact with the plurality of second conductive portions 105. There might be no intervening components between the insulating layer 103 and the plurality of second conductive portions 105. The insulating layer 103 may prevent any unwanted direct current paths between the plurality of first conductive portions 101 and the plurality of second conductive portions 105. The insulating layer 103 may prevent direct current paths between first conductive portions 101A in the first subset and second conductive portions 105B in the second subset. The insulating layer 103 may also prevent direct current paths between first conductive portions 101B in the second subset and second conductive portions 105A in the first subset.

The second conductive portions 105 extend across the gaps between first conductive portions 101 within the same subsets. This means that a second conductive portion 105 can extend between two first conductive portions 101A from the first subset or can extend between two conductive portions 101B from the second subset but a second conductive portion 105 does not extend between a first conductive portion 101A from the first subset and a first conductive portion 101B from the second subset. This configuration ensures that second conductive portions 105A in the first subset are only connected to first conductive portions 101A in the first subset. Similarly the second conductive portions 105B in the second subset are only connected to first conductive portions 101B in the second subset. This provides a direct current path between first conductive portions 101 within the same subsets.

These connections enable the first conductive portions 101 and the second conductive portions 105 to form a pair of transmission lines 109A, 109B. The first subsets 101A, 105A form a first transmission line 109A and the second subsets 101B, 105B form a second transmission line 109B.

In the example shown in Fig. 1C each of the second conductive portions 105 has the same, or substantially the same shape. In the example shown in Fig. 1C the second conductive portions 105 are formed in an S shape. The S shape used for the second conductive portions 105 is a mirror image of the reverse S shape used for the first conductive portions 101. The S extends diagonally from a bottom left point to a top right point. It is to be appreciated that other shapes and configurations of the second conductive portions 105 could be used in other examples of the disclosure.

The method shown in Figs. 1A to 1C enables a conductive thread 107 to be formed. The conductive thread comprises a pair of transmission lines 109A, 109B which are twisted around an insulating core 103. The pair of transmission lines 109A, 109B may provide for a conductive thread 107 with improved noise tolerance compared to a wire or conductive trace.

Other types of conductive thread 107 may be formed using variations of the method. For instance in some examples the conductive thread 107 could comprise a single transmission line 109. In such examples the respective pluralities of conductive portions 101, 105 would be formed in a single set.

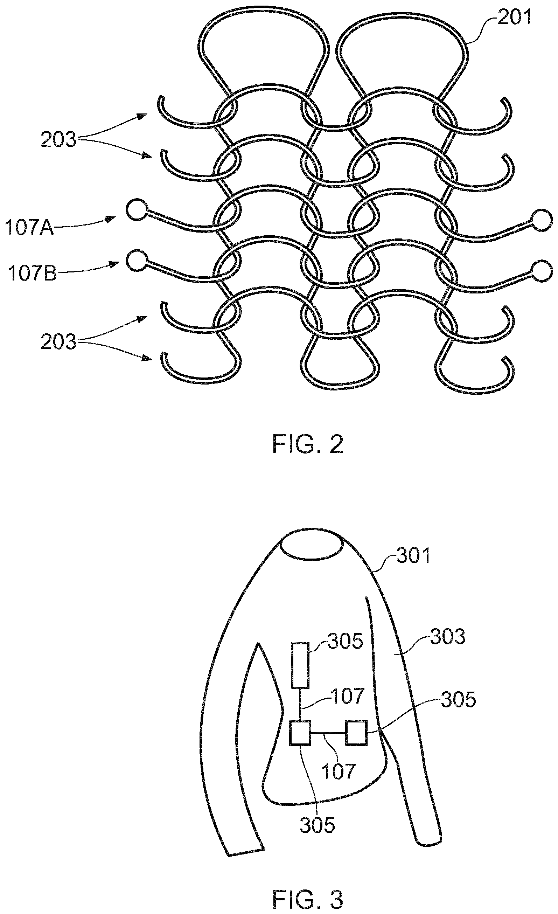

Fig. 2 shows an example fabric 201 that may comprise a conductive thread 107. The example shown in Fig. 2 shows a section of the fabric 201. It is to be appreciated that the fabric could comprise more threads and loops and cover a larger surface than shown in Fig. 2.

In the example of Fig. 2 the fabric 201 comprises a first conductive thread 107A, a second conductive thread 107B and a plurality of non-conductive threads 203.

The first conductive thread 107A and the second conductive thread 107B could be formed using any suitable method. In the example of Fig. 2 both of the conductive threads 107A, 107B may comprise a twisted transmission line pair. It is to be appreciated that in other examples only one or more than two conductive treads 107 comprising a twisted transmission line pair could be provided. In some examples the conductive threads 107A, 107B could comprise insulating yarn which may be coated with one or more conductive layers. The one or more conductive layers could comprise a twisted transmission line pair. An insulating layer could be provided over the one or more conductive layers. The insulating yarn could comprise nylon, polyester, cotton or any other suitable material. The one or more conductive layers could comprise silver, gold, carbon, nickel, copper or any other suitable material. The one or more conductive layers could be formed from an ink paste. The insulating layer could be formed from polyurethane, polyester, acrylic polymers or any other suitable material. Other types of thread could be used in other examples of the disclosure.

The non-conductive threads 203 may comprise any suitable type of thread. In some examples the non-conductive threads 203 could comprise nylon, polyester, cotton or any other suitable type of material. In some examples the non-conductive threads 203 could comprise the same type of thread as is used for the insulating yarn of the conductive threads 107A, 107B. The type of thread that is used may be dependent upon the type of fabric 201 that is being formed.

In the example shown in Fig. 2 the conductive threads 107A, 107B are woven into the fabric using a weft knitting process. The weft knitting process comprises looping together the respective threads 107A, 107B, 203. When the fabric 201 is formed using the weft knitting process the respective threads 107A, 107B, 203 extend in rows across the fabric 201. Having the respective threads 107A, 107B, 203 extend in rows across the fabric 201 may reduce the interference between the conductive threads 107A, 107B within the fabric 201. The use of the weft knitting process may reduce the interference between the conductive threads 107A, 107B within the fabric 201 as compared to fabrics formed using other knitting processes such as warp knitting.

In the example shown in Fig. 2 the first conductive thread 107A and the second conductive thread 107B are provided adjacent to each other within the fabric 201. There are no non-conductive threads 203 provided between the first conductive thread 107A and the second conductive thread 107B. As the warp knitting process has been used the two conductive threads 107A, 107B extend in two adjacent rows along the fabric 201. It is to be appreciated that other configurations for the conductive threads 107A, 107B within the fabric 201 could be used in other examples of the disclosure.

In the example of Fig. 2 the conductive threads 107A, 107B may be formed as the fabric 201 is being formed. This may enable the conductive threads 107A, 107B to be integrated within the fabric 201 rather than formed on top of the fabric 201. This may make the fabric 201 cheaper to manufacture compared to fabrics where the conductive threads 107A, 107B are provided on the surface of the fabric 201.

Fig. 3 shows a wearable electronic device 301 comprising conductive thread 107 that may be formed using the example methods described above.

In the example of Fig. 3 the wearable electronic device 301 comprises a garment 303 comprising one or more conductive threads 107. The garment 303 comprises an item of clothing which is arranged to be worn by a subject. In the example of Fig. 3 the garment 303 comprises a shirt. Other items of clothing could be used in other examples of the disclosure. For instance the item of clothing could comprise a strap which could be attached to any suitable part of a subject's body, or any other suitable article of clothing.

In the example of Fig. 3 the one or more conductive threads 107 may provide a connector between different electronic components 305 within the wearable electronic device 301. The one or more conductive threads 107 could be woven into the fabric of the garment 303, could be used to provide stitching within the garment 303 or could be secured within the garment 303 using any other suitable means.

Examples of the disclosure therefore provide conductive thread 107 that is formed using two dimensional printing processes. This also provides conductive thread 107 and fabrics 201 formed from the conductive threads 107 that are suitable for use in wearable electronic devices.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to 'comprising only one...' or by using 'consisting'.

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Although embodiments have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

Although features have been described with reference to certain embodiments, those features may also be present in other embodiments whether described or not.

The term 'a' or 'the' is used in this document with an inclusive not an exclusive meaning. That is any reference to X comprising a/the Y indicates that X may comprise only one Y or may comprise more than one Y unless the context clearly indicates the contrary. If it is intended to use 'a' or 'the' with an exclusive meaning then it will be made clear in the context. In some circumstances the use of 'at least one' or 'one or more' may be used to emphasis an inclusive meaning but the absence of these terms should not be taken to infer and exclusive meaning.

The presence of a feature (or combination of features) in a claim is a reference to that feature) or combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can' or 'may' refers to a particular instance in a class of examples. A property of the instance can be a property of only that instance or a property of the class or a property of a sub-class of the class that includes some but not all of the instances in the class. It is therefore implicitly disclosed that a feature described with reference to one example but not with reference to another example, can where possible be used in that other example as part of a working combination but does not necessarily have to be used in that other example.

Whilst endeavoring in the foregoing specification to draw attention to those features believed to be of importance it should be understood that the Applicant may seek protection via the claims in respect of any patentable feature or combination of features hereinbefore referred to and/or shown in the drawings whether or not emphasis has been placed thereon.

## Claims

1. A conductive thread comprising:
a plurality of first conductive portions;
at least one insulating layer, wherein the at least one insulating layer overlays at least part of the plurality of first conductive portions; and
a plurality of second conductive portions overlaying at least part of the at least one insulating layer so that the plurality of second conductive portions contacts the plurality of first conductive portions to form at least one transmission line;
wherein the plurality of first conductive portions, the insulating layer, and the plurality of second conductive portions are formed using one or more two dimensional printing processes.

2. A conductive thread as claimed in any preceding claim wherein the plurality of first conductive portions comprise at least a first subset and a second subset and the plurality of second conductive portions also comprise at least a first subset and a second subset wherein at least the first subset and the second subset are configured to form a pair of transmission lines.

3. A conductive thread as claimed in claim 2 wherein the pair of transmission lines are formed in a twisted configuration.

4. A conductive thread as claimed in any preceding claim wherein respective parts of the conductive thread are formed using different two dimensional printing processes and the respective parts comprise the plurality of first conductive portions, the at least one insulating layer, and a plurality of second conductive portions.

5. A conductive thread as claimed in any preceding claim wherein the two dimensional printing processes comprise one or more of; ink jet printing, screen printing, spray coating.

6. A fabric formed using one or more conductive threads as claimed in any preceding claim.

7. A fabric as claimed in claim 6 wherein the fabric is formed using a weft knitting process.

8. A fabric as claimed in any of claims 6 to 7 wherein the fabric also comprises one or more non-conductive threads.

9. A wearable electronic device comprising a conductive thread as claimed in any of claims 1 to 5 and/or a fabric as claimed in any of claims 6 to 8.

10. A wearable electronic device as claimed in claim 9 wherein the conductive thread provides a connector within the wearable electronic device.

11. A method of forming a conductive thread comprising:
forming a plurality of first conductive portions;
forming an insulating layer, wherein the first insulating layer overlays at least part of the plurality of first conductive portions; and
forming a plurality of second conductive portions overlaying at least part of the insulating layer so that the plurality of second conductive portions contacts the plurality of first conductive portions to form at least one transmission line;
wherein each of the plurality of first conductive portions, the insulating layer, and the plurality of second conductive portions are formed using one or more two dimensional printing processes.

12. A method as claimed in claim 11 wherein the plurality of first conductive portions comprise at least a first subset and a second subset and the plurality of second conductive portions form at least a second subset wherein at least the first subset and the second are configured to form a pair of transmission lines.

13. A method as claimed in claim 12 wherein the pair of transmission lines are formed in a twisted configuration.

14. A method as claimed in any of claims 11 to 13 wherein respective parts of the conductive thread are formed using different two dimensional printing processes and the respective parts comprise the plurality of first conductive portions, the at least one insulating layer, and a plurality of second conductive portions.

15. A method as claimed in any of claims 11 to 14 wherein the two dimensional printing processes comprise one or more of; ink jet printing, screen printing, spray coating.
